# EUROPEAN PATENT SPECIFICATION

(11) **EP 4 401 098 B1**
(45) Date of publication and mention of the grant of the patent: **13.08.2025**
(21) Application number: 23218117.2
(22) Date of filing: 19.12.2023
(51) Int. Cl.: H01F 27/28, H01F 5/04, H01F 27/29, H01F 27/06, H01F 41/076

(54) **MAGNETIC DEVICE AND MANUFACTURING METHOD THEREOF, AND ELECTRONIC DEVICE**
MAGNETISCHE VORRICHTUNG UND HERSTELLUNGSVERFAHREN DAFÜR SOWIE ELEKTRONISCHE VORRICHTUNG
DISPOSITIF MAGNÉTIQUE ET SON PROCÉDÉ DE FABRICATION, ET DISPOSITIF ÉLECTRONIQUE

(30) Priority: 13.01.2023 CN 202310075771
(43) Date of publication of application: 17.07.2024
(73) Proprietor: Huawei Digital Power Technologies Co., Ltd., Shenzhen, 518043 (CN)
(72) Inventor: BI, Jianguo, Shenzhen, 518043 (CN); LIN, Run, Shenzhen, 518043 (CN); CHEN, Huicheng, Shenzhen, 518043 (CN)
(74) Representative: Epping - Hermann - Fischer

(56) References cited:
- EP-A1- 1 103 995
- CN-A- 109 378 169
- CN-A- 111 653 417
- CN-U- 202 102 848
- US-A1- 2004 169 567

## Description

### TECHNICAL FIELD

This application relates to the field of power electronic technologies, and in particular, to a magnetic device and a manufacturing method thereof, and an electronic device.

### BACKGROUND

Magnetic devices are electronic components that convert electric energy and magnetic energy into each other according to the principle of electromagnetic induction to implement energy conversion and transmission. A plurality of magnetic devices are mounted on a PCB (Printed Circuit Board printed circuit board) to implement electrical connections of the plurality of magnetic devices, so that a current or a signal can be transferred among the magnetic devices. A PCB is a carrier of many electronic components in electronic products, and makes an order connection of the electronic components possible. The PCB has become a core part of modern electronic products. A pin of a magnetic device undertakes functions of through-current, fixing, and heat dissipation. A pin is made of a copper wire winding with soldering tin and is inserted onto a PCB. A through-current area of the existing copper pin is the same as that of the winding. The temperature resistance of materials for magnetic devices is 150°C or above. The temperature resistance of PCBs is limited by board materials. The allowed temperature resistance of PCBs is lower than 115°C. The temperature resistance of device materials is not fully utilized.

In practice, copper is expensive and heavy. An aluminum wire winding is gradually used to replace the copper wire winding, to reduce costs. A conductor on a surface of a PCB is copper. When a copper wire and an aluminum wire are connected, there is a specific potential difference between the copper wire and the aluminum wire due to different materials. If there is water vapor, electrolysis is caused to produce copper oxide and aluminum oxide. In this case, a contact surface is gradually corroded and oxidized, resulting in poor contact at the contact surface, increased contact resistance, and hot wires, and consequently causing accidents. Therefore, it is difficult to prevent a magnetic device with an aluminum wire from being oxidized when being soldered to a PCB.

In order to resolve the problem in soldering of an aluminum wire inductor and a PCB, in practice, one end of an aluminum wire and one end of a copper wire are soldered, and the other end of the copper wire is tin-coated and then soldered to a PCB. The introduction of copper-aluminum soldering requires protection on a plurality of soldering joints, resulting in cumbersome processes and high costs. In practice, an aluminum wire is ultrasonically coated with Sn-Zn solder, and then the aluminum wire is soldered to a PCB. However, a soldering joint cracks when the temperature is above 85°C and the air humidity is above 85 % for more than 400 hours.

EP 1 103 995 A1 discloses an electronic apparatus with a circuit board including a through hole into which a wire is inserted, the wire being an external terminal of a first electronic component such as a resistor, capacitor or inductor. The document describes that the wire comprises a metal wire made of iron or copper over which a Sn-Cu alloy layer and a plating metal layer made of nickel or copper are formed, and that the Sn-Cu alloy layer is formed over the metal wire via the plating metal layer.

CN 111 653 417 A discloses a plug-in type integrally formed inductor, comprising a coil and a magnetic main body wrapping the outer side of the coil. A first welding pin and a second welding pin which extend downwards are arranged at the two ends of the coil respectively, a plurality of bosses are arranged at the bottom of the magnetic main body, and a plurality of heat dissipation grooves are formed between the bosses.

CN 202 102 848 U discloses an aluminum wire inductor which can be easily welded on a circuit board through common soldering tin in a common welding manner. The inductor is welded on the circuit board through soldering tin and comprises an iron core wound by an enameled wire, the enameled wire comprises a conducting wire and an insulating layer, the conducting wire in the enameled wire is an aluminum wire, and a soldering layer is arranged at the connecting end of the aluminum wire.

CN 109 378 169 A discloses an electric reactor comprising multiple iron core columns, coils, upper iron yokes and lower iron yokes, wherein the coils, the upper iron yokes and the lower iron yokes sleeve the iron core columns, the electric reactor further comprising an insulating fixing frame, the insulating fixing frame comprises a back plate, a first supporting plate and a second supporting plate, the back plate comprises a first surface and a second surface which are opposite, the first supporting plate and the second supporting plate are perpendicularly connected with and parallel to the first surface separately, the iron core columns are arranged between the first supporting plate and the second supporting plate side by side, the upper iron yokes are arranged on the surface, back onto the second supporting plate, of the first supporting plate, the lower iron yokes are arranged on the surface, back onto the first supporting plate, of the second supporting plate, the back plate is further provided with multiple lead holes, the coils comprise lead terminals, and the lead terminals run through the lead holes and are located outside the second surface.

US 2004/169567 A1 discloses a common mode choke coil comprising: a holder including side walls which have wire guide strips respectively formed at their sides and which have vertical guide grooves and horizontal flange stoppers both formed at their inner side surfaces; a coil assembly with edgewise windings of a rectangular wire provided around a bobbin with flanges; and a core securing plate spring, wherein the coil assembly is fixedly set in a correct position inside the holder such that protrusions formed at the flanges are put through the guide grooves thereby fixedly holding the bobbin in place horizontally while the flanges are locked by the flange stoppers thereby fixedly holding the bobbin in place vertically, and wherein lead wires of the edgewise windings are bent at upper ends of the wire guide strips, and then extend along the wire guide strips.

### SUMMARY

To resolve the foregoing problems, embodiments of this application provide a magnetic device and a method for manufacturing the magnetic device. The invention is defined by the appended claims.

According to a first aspect of the present invention, this application provides a magnetic device as defined in present claim 1. The magnetic device includes a magnetic core, a base, a winding, and a plurality of pins. Parts of two ends of the winding that pass through the base are the pins. A first metal layer and a second metal layer are sequentially stacked on a part or all of a side surface of each pin. The first metal layer is coated on a part or all of the side surface of each pin. The second metal layer is coated on an outer side of the first metal layer. The two metal layers are coated on an outer surface of each pin, which increases a transverse section area of each pin, increases soldering strength between each pin and a circuit board, reduces heat generated from a contact point between each pin and the circuit board, and increases a through-current capability of each pin. In a possible implementation, not forming part of the present invention, the winding includes a copper wire, parts of two ends of the copper wire that pass through the base of the magnetic device are the pins, the first metal layer includes copper foil, and the second metal layer includes a tin layer or a tin alloy layer. When the winding includes the copper wire, the first metal layer also includes the copper foil. In this case, there is no potential difference between metals of a same type, thereby reducing soldering difficulty. In addition, a surface of a PCB is metal copper, so that there is also no potential difference in soldering of metals of a same type, thereby increasing mechanical strength of soldering the magnetic device to the PCB. The second metal layer includes the tin layer or the tin alloy layer. Tin has a low melting point and can be quickly solidified, which facilitates soldering of the magnetic device to the PCB.

In a possible implementation, not forming part of the present invention, the winding includes an aluminum wire, parts of two ends of the aluminum wire that pass through the base of the magnetic device are the pins, the first metal layer includes copper foil, and the second metal layer includes a tin layer or a tin alloy layer. The copper foil may be soldered to a surface of the pin by using an ultrasonic soldering process, so that the copper foil is coated on the surface of the pin, to facilitate soldering the pin to the PCB. The second metal layer includes the tin layer or the tin alloy layer. Tin has a low melting point and can be quickly solidified, which facilitates soldering of the magnetic device to the PCB.

In a possible implementation, according to the present invention, the winding includes an aluminum wire, the first metal layer includes copper-aluminum composite foil, and the second metal layer includes a tin layer or a tin alloy layer. The copper-aluminum composite foil includes two layers. A first layer of the copper-aluminum composite foil is an aluminum layer, and a second layer of the copper-aluminum composite foil is a copper layer. The aluminum layer of the copper-aluminum composite foil is in contact with the winding, and the copper layer of the copper-aluminum composite foil is in contact with the second metal layer, which can slow down the generation of a potential difference between copper and aluminum, thereby preventing accidents caused by poor contact.

In a possible implementation, a transverse section of the pin is of a U shape, a circular shape, or a rectangular shape. A longitudinal section of the pin is of a rectangular shape, a T shape, or a trapezoidal shape. By adopting the above shapes, a through-current area and volume of the pin can be increased. According to the formulas Q = I²*R*t (where Q is heat generated by the pin, I is a current value of the pin, R is a resistance value of the pin, and t is power-on time) and R = ρ*L/S (where ρ is resistivity of the pin, L is a length of the pin, and S is a cross-sectional area of the pin), it can be learned that the resistance R of the pin is inversely proportional to the cross-sectional area S of the pin. The first metal layer and the second metal layer are sequentially coated on the outer surface of the pin. In this case, the cross-sectional area S of the pin increases, the resistance R of the pin decreases, and the heat Q generated by the pin decreases. Therefore, the heat generated from the contact point between the pin and the circuit board is reduced. In addition, according to the specific heat capacity formula c = Q/(m*ΔT) (where c is specific heat capacity of the pin, Q is absorbed (or released) heat, m is mass of the pin, and ΔT is an amount of temperature change after heat absorption (or heat release)), when the specific heat capacity c of the pin is a fixed value, the mass m of the pin increases, the heat Q generated by the pin decreases, and ΔT decreases. Therefore, the temperature rise of the pins is reduced. In addition, the cross-sectional area S of the pin increases, resulting in an increase in a soldering area between the pin and the circuit board, thereby increasing mechanical strength of a connection between the pin and the circuit board. Moreover, the current flowing through the pin per unit time is increased, thereby enhancing a through-current capability of the pin.

According to a second aspect of the present invention, this application provides a method for manufacturing a magnetic device as defined in present claim 4. The magnetic device includes a magnetic core, a base, a winding, and a plurality of pins. Parts of two ends of the winding that pass through the base are the pins. A first metal layer and a second metal layer are sequentially stacked on a part or all of a side surface of a pin. The method for manufacturing the magnetic device includes: winding the winding on a winding framework of the magnetic device; soldering the first metal layer to a part or all of the side surface of the pin; assembling the magnetic core and the base; and immersing the pin in tin, soldering the second metal layer to an outer side of the first metal layer, and removing a solder icicle. The manufacturing method simplifies a manufacturing process and procedure of the pin in the magnetic device. The magnetic device manufactured according to the method has a high through-current capability and high mechanical strength.

According to a third aspect of the present invention, this application provides an electronic device as defined in present claim 5. The electronic device includes a circuit board and the magnetic device as described above. The magnetic device is mounted on the circuit board by using the pins. The magnetic device includes a magnetic core, a winding, and a plurality of pins. In an extension direction of a pin, a first metal layer and a second metal layer are sequentially stacked on a part or all of a side surface of the pin. The first metal layer is coated on a part or all of the side surface of the pin, and the first metal layer has low resistivity. The second metal layer is coated on an outer side of the first metal layer, and the second metal layer has a low melting point and can be quickly solidified, which facilitates soldering.

### BRIEF DESCRIPTION OF DRAWINGS

FIG. 1 is a schematic diagram of a structure of a magnetic device according to an embodiment of this application;
FIG. 2 is a bottom view of a magnetic device according to an embodiment of this application;
FIG. 3 is a top view of a first type of pin of a magnetic device according to an embodiment of this application;
FIG. 4 is a top view of a second type of pin of a magnetic device according to an embodiment of this application;
FIG. 5 is a top view of a third type of pin of a magnetic device according to an embodiment of this application;
FIG. 6 is a side view of a first type of pin of a magnetic device according to an embodiment of this application;
FIG. 7 is a side view of a second type of pin of a magnetic device according to an embodiment of this application;
FIG. 8 is a side view of a third type of pin of a magnetic device according to an embodiment of this application; and
FIG. 9 is a side view of a fourth type of pin of a magnetic device according to an embodiment of this application.
   100-Magnetic device
   101-Winding; 103-Base; 105-Pin; 107-Magnetic core;
   1051-First metal layer; and 1052-Second metal layer.

### DESCRIPTION OF EMBODIMENTS

To make the objectives, technical solutions, and advantages of embodiments of this application clearer, the following describes embodiments of this application in detail with reference to the accompanying drawings. Terms used in implementations of this application are only used to explain specific embodiments of this application, but are not intended to limit this application. It is clear that the described embodiments are merely some rather than all of embodiments of this application. Implementations described in the following example embodiments do not represent all implementations consistent with this application. On the contrary, the implementations are merely examples of apparatuses and methods that are described in the appended claims in detail and that are consistent with some aspects of this application.

For ease of understanding, terms in embodiments of this application are first explained.
(1) The term "and/or" describes only an association relationship for describing associated objects and represents that three relationships may exist. For example, A and/or B may represent the following three cases: Only A exists, both A and B exist, and only B exists.
(2) The term "a plurality of" means two or more than two.
(3) The term "cold pressure welding" is a method of solid-phase welding implemented by plastic deformation of a to-be-welded metal under pressure at room temperature. Impurities such as oxide films on an interface of a connection part are extruded out through plastic deformation, so that pure metals are in close contact with each other to achieve intergranular bonding. In this case, a softened zone, a heat affected zone, and a brittle intermetallic phase that are common to thermal welding joints are not generated. The cold pressure welding is mainly used for metals with good plasticity (such as aluminum and copper).
(4) The term "resistance welding" is a welding method by passing a current through a weldment, locally heating the weldment by using resistance heat generated at a contact point as a heat source, and applying pressure. In this welding method, no filler metal is required, productivity is high, deformation of the weldment is small, and automation is easy to be achieved. The resistance welding is a method of metal binding formed by heating workpieces to a molten or plastic state based on thermal resistance effect generated by passing a current through a contact surface and adjacent regions of the workpieces. There are four main methods for resistance welding, namely spot welding, seam welding, projection welding, and butt welding.
(5) The term "ultrasonic welding" is for fusion between molecular layers due to friction between surfaces of two to-be-welded objects under pressure by transmitting high-frequency vibration waves to the surfaces of the two objects.
(6) The term "wave soldering" is to contact a to-be-soldered surface of a PCB on which components are mounted with molten solder in a circulating wave driven by an electromagnetic pump, so that the solder and a base metal undergo a metallurgical reaction at a set speed and direction to form new metal structure soldering joints, to complete connection of the metal.
(7) The term "laser welding" is a highly efficient and precise welding method that uses laser beams of high energy density as a heat source. The laser welding is one of the important application aspects of laser material processing technologies. In the 1970s, the laser welding is mainly used in welding thin-walled materials and low-speed welding. The welding process is of a heat conduction type. To be specific, a surface of a workpiece is heated by laser radiation, and heat on the surface diffuses inward due to heat conduction. Parameters such as width, energy, peak power, and repetition frequency of a laser pulse are controlled to melt the workpiece to form a specific molten pool.
(8) The term "reflow soldering" is to connect one or more electronic components to a contact pad by using soldering paste (a mixture of solder and flux), and melt the solder by controlled heating to form a permanent joint. The soldering may be performed by using different heating methods, for example, using a reflow oven, an infrared heat lamp, or a heat gun.

A magnetic device includes a coil and a soft magnetic material. After a current passes through, the coil generates a magnetic field, and the magnetic material converges magnetic field lines. The magnetic field disappears after powering off. Magnetic devices mainly include power transformers, signal transformers, inductors, and the like. However, due to different application scenarios, the devices have various structures and material forms. A magnetic device usually includes a winding and a magnetic core. A transformer usually includes more than two windings, and therefore includes more than four pins. An inductor is a component that can convert electrical energy into magnetic energy and store the magnetic energy, and usually includes one winding and more than two pins. Magnetic devices are connected by soldering pins of the magnetic devices on a circuit board.

In practice, a pin of a magnetic device is soldered on a PCB, and the pin is usually made of a copper wire winding or an aluminum wire winding. However, copper is expensive and heavy. An aluminum wire winding is gradually used to replace the copper wire winding, to reduce costs. A conductor on a surface of a PCB is copper. When a copper wire and an aluminum wire are connected, there is a specific potential difference between the copper wire and the aluminum wire due to different materials. If there is water vapor, electrolysis is caused to produce copper oxide and aluminum oxide. In this case, a contact surface is gradually corroded and oxidized, resulting in poor contact at the contact surface, increased contact resistance, and hot wires, and consequently causing accidents. In addition, as a PCB is increasingly widely used in high-power scenarios, it is critical to improve a through-current capability, mechanical strength, and reliability of the magnetic device for application of the magnetic device in high-power scenarios.

To resolve the foregoing problems, this application provides a magnetic device and a manufacturing method thereof, and an electronic device. The magnetic device in embodiments of this application has a simple manufacturing process, can be better soldered to a circuit board, has good heat conduction effect, and improves mechanical strength of fixing the magnetic device on the circuit board.

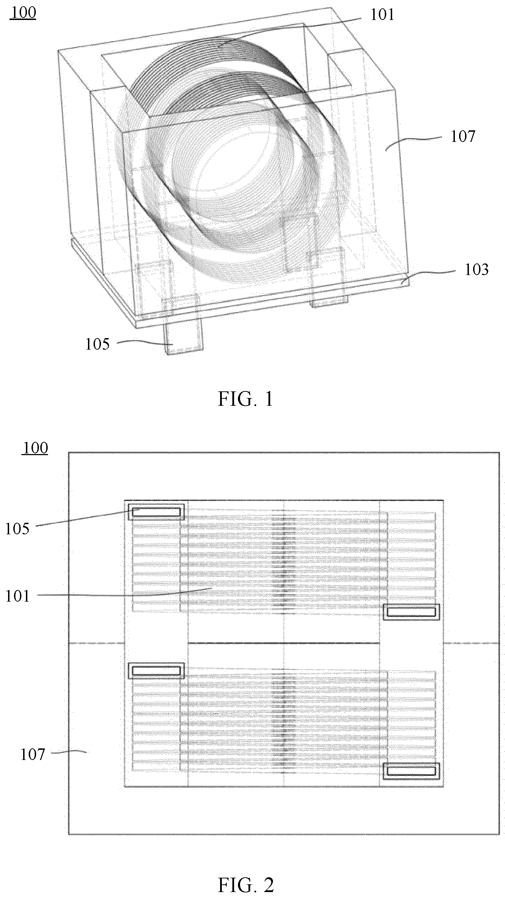

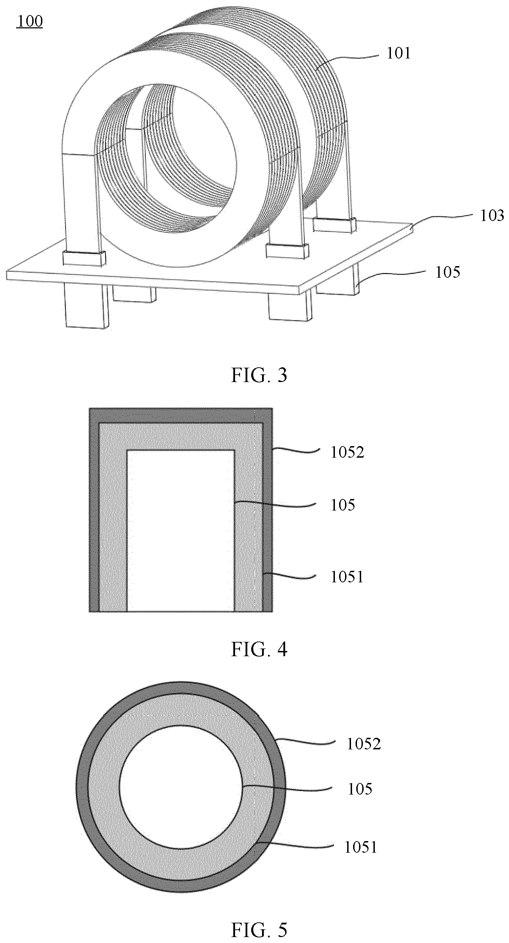

Refer to FIG. 1 to FIG. 3. FIG. 1 is a schematic diagram of a structure of a magnetic device 100 according to an embodiment of this application. FIG. 2 is a bottom view of the magnetic device 100 according to an embodiment of this application. FIG. 3 is a top view of a pin 105 of the magnetic device 100 according to an embodiment of this application. An embodiment of this application provides a magnetic device 100. The magnetic device 100 includes a magnetic core 107, a winding 101, and a plurality of pins 105. Parts of two ends of the winding that pass through a base 103 are the pins 105. A first metal layer 1051 and a second metal layer 1052 are sequentially stacked on a part or all of a side surface of a pin 105. The first metal layer 1051 is coated on a part or all of the side surface of the pin 105. The second metal layer 1052 is coated on an outer side of the first metal layer 1051. The first metal layer 1051 has low resistivity. The second metal layer 1052 has a low melting point and can be quickly solidified, which facilitates soldering.

A process of coating the first metal layer 1051 on the side surface of the pin 105 is not specifically limited in this embodiment of this application. For example, the first metal layer 1051 may be soldered on the surface of the pin 105 by using various processes such as cold pressure welding, resistance welding, or ultrasonic welding.

A process of coating the second metal layer 1052 on the outer side of the first metal layer 1051 is not specifically limited in this embodiment of this application. For example, by using an impregnation method, the first metal layer 1051 may be immersed in a liquid phase of the second metal and taken out after a period of time elapses. In this case, the second metal layer 1052 is solidified on the surface of the first metal layer 1051.

In a possible implementation, not forming part of the present invention, the winding 101 includes a copper wire, the first metal layer 1051 on the surface of the pin 105 includes copper foil, and the second metal layer 1052 includes a tin layer or a tin alloy layer. When the winding includes the copper wire, the first metal layer 1051 also includes the copper foil. In this case, there is no potential difference between metals of a same type, thereby reducing soldering difficulty. In addition, a surface of a PCB is metal copper, so that there is also no potential difference in soldering of metals of a same type, thereby increasing mechanical strength of soldering the magnetic device 100 to the PCB. The second metal layer 1052 includes a tin layer or a tin alloy layer. The second metal layer 1052 has a low melting point and can be quickly solidified, which facilitates soldering of the magnetic device 100 to the PCB.

A specific material of the second metal layer 1052 is not limited in this embodiment of this application. For example, the second metal layer 1052 may be a tin layer or a tin alloy layer, and the tin alloy layer includes a tin-copper alloy, a tin-zinc alloy, a tin-silver alloy, or the like.

Usually, a coil of the magnetic device 100 is wound using a copper wire. Characterized by moderate costs, low resistivity, excellent tensile strength or elongation, and easy processing, the copper wire is widely used in the magnetic device 100. In addition, the coil may alternatively be wound using an aluminum wire. In terms of mechanical properties of the wire, tensile strength or elongation of the aluminum wire is lower than that of the copper wire, which can meet requirements of a product winding on the mechanical properties, and make the winding of the coil easier and more convenient, thereby saving processing time. In terms of specific gravity of the wire, density of copper is 3.3 times that of aluminum, and therefore weight of the aluminum wire is one third of that of the copper wire with a same cross-sectional area and length, so the use of the aluminum wire can save costs and resources.

In a possible implementation, not forming part of the present invention, the winding 101 includes an aluminum wire, the first metal layer 1051 includes copper foil, and the first metal layer 1051 is soldered to the surface of the pin 105 by using an ultrasonic process. The use of the aluminum wire for the winding 101 reduces costs and simplifies a manufacturing process of the winding 101. The second metal layer 1052 includes a tin layer or a tin alloy layer. The second metal layer 1052 has a low melting point and can be quickly solidified, which facilitates soldering of the magnetic device 100 to the PCB.

In a possible implementation, according to the present invention, the winding 101 includes an aluminum wire, the first metal layer 1051 includes copper-aluminum composite foil, and the second metal layer 1052 includes a tin layer or a tin alloy layer. When the winding 101 includes the aluminum wire, the first metal layer 1051 is coated on the side surface of the pin 105, and the first metal layer 1051 includes the copper-aluminum composite foil. The copper-aluminum composite foil includes two layers. A first layer of the copper-aluminum composite foil is an aluminum layer, and a second layer of the copper-aluminum composite foil is a copper layer. The aluminum layer is in contact with the winding 101, and the copper layer is in contact with the second metal layer, which can slow down the generation of a potential difference between copper and aluminum, thereby preventing accidents.

The second metal layer 1052 may be a tin alloy, such as a tin-copper alloy, a tin-zinc alloy, or a tin-silver alloy. When the foregoing layers are specifically provided in the structures, thickness of the first metal layer 1051 and thickness of the second metal layer 1052 are not strictly limited, and may be adjusted according to an actual requirement. Specifically, when the following conditions are met, good effects can be achieved. For example, when the first metal layer 1051 includes copper foil, the thickness is usually 0.0035 mm-5 mm. When the first metal layer 1051 includes copper-aluminum composite foil, the thickness is usually 0.035 mm-5 mm, where the copper layer is about 0.00525 mm. When the second metal layer 1052 includes a tin-copper alloy layer, the thickness of the second metal layer 1052 is usually about 10 µm.

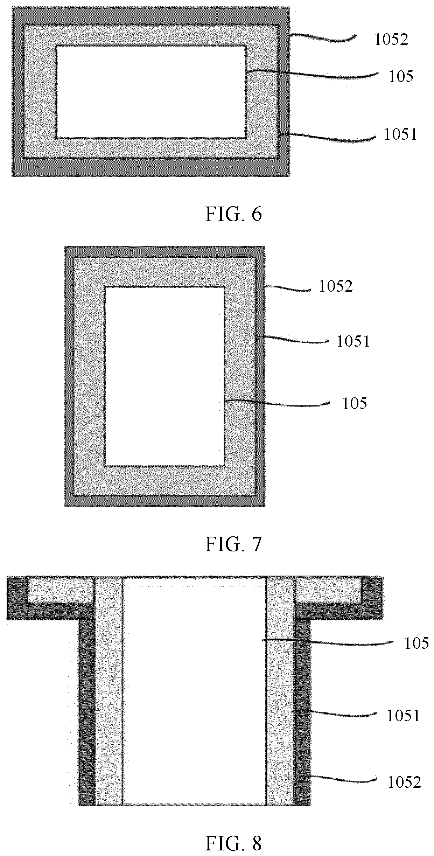

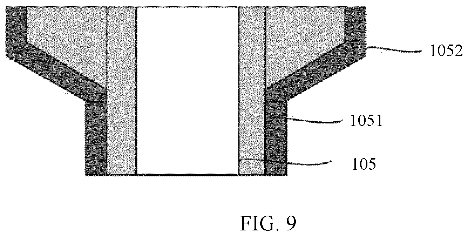

A section shape of the pin 105 is not specifically limited in this embodiment of this application. For example, FIG. 4 to FIG. 6 are top views of the pin 105, and a transverse section of the pin 105 is of a U shape, a circular shape, or a rectangular shape. FIG. 7 to FIG. 9 are side views of the pin 105, and a longitudinal section of the pin 105 is of a rectangular shape, a T shape, or a trapezoidal shape. By adopting the above shapes, a through-current area and volume of the pin 105 can be increased. According to the formulas Q = I²*R*t (where Q is heat generated by the pin 105, I is a current value of the pin 105, R is a resistance value of the pin 105, and t is power-on time) and R = ρ*L/S (where ρ is resistivity of the pin 105, L is a length of the pin 105, and S is a cross-sectional area of the pin 105), it can be learned that the resistance R of the pin 105 is inversely proportional to the cross-sectional area S of the pin 105. The first metal layer 1051 and the second metal layer 1052 are sequentially coated on the outer surface of the pin 105. In this case, the cross-sectional area S of the pin 105 increases, the resistance R of the pin 105 decreases, and the heat Q generated by the pin 105 decreases. Therefore, the heat generated from the contact point between the pin 105 and the circuit board is reduced. In addition, according to the specific heat capacity formula c = Q/(m*ΔT) (where c is specific heat capacity of the pin 105, Q is absorbed (or released) heat, m is mass of the pin 105, and ΔT is an amount of temperature change after heat absorption (or heat release)), when the specific heat capacity c of the pin 105 is a fixed value, the mass m increases, the heat Q generated by the pin 105 decreases, and ΔT decreases. Therefore, the temperature rise of the pins 105 is reduced. In addition, the cross-sectional area S of the pin 105 increases, resulting in an increase in a soldering area between the pin 105 and the circuit board, thereby increasing mechanical strength of a connection between the pin 105 and the circuit board. Moreover, the current flowing through the pin 105 per unit time is increased, thereby enhancing a through-current capability of the pin 105.

In a possible implementation, the transverse section of the pin 105 is of a U shape, and the longitudinal section is of a rectangular shape. When the transverse section is of the U shape, the first metal layer 1051 and the second metal layer 1052 are coated on three side surfaces of the pin 105, which saves materials of the first metal layer 1051 and the second metal layer 1052, facilitates a processing procedure of the pin 105, and increases a contact area between the pin 105 and the circuit board, thereby increasing soldering strength between the magnetic device 100 and the circuit board, reducing heat generated from a contact point between the pin 105 and the circuit board, and increasing a through-current area of the pin 105. When the longitudinal section is of the rectangular shape, a heat dissipation area of the pin 105 is increased, thereby achieving good heat dissipation effect.

In a possible implementation, the transverse section of the pin 105 is of a U shape, and the longitudinal section is of a T shape. When the transverse section is of the U shape, the first metal layer 1051 and the second metal layer 1052 are coated on three side surfaces of the pin 105, which saves materials of the first metal layer 1051 and the second metal layer 1052, facilitates a processing procedure of the pin 105, and increases a contact area between the pin 105 and the circuit board, thereby increasing soldering strength between the magnetic device 100 and the circuit board, reducing heat generated from a contact point between the pin 105 and the circuit board, and increasing a through-current area of the pin 105. When the longitudinal section is of the T shape, a heat dissipation area of the pin 105 is increased, thereby achieving good heat dissipation effect.

In a possible implementation, the transverse section of the pin 105 is of a U shape, and the longitudinal section is of a trapezoidal shape. When the transverse section is of the U shape, the first metal layer 1051 and the second metal layer 1052 are coated on three side surfaces of the pin 105, which saves materials of the first metal layer 1051 and the second metal layer 1052, facilitates a processing procedure of the pin 105, and increases a contact area between the pin 105 and the circuit board, thereby increasing soldering strength between the magnetic device 100 and the circuit board, reducing heat generated from a contact point between the pin 105 and the circuit board, and increasing a through-current area of the pin 105. When the longitudinal section is of the trapezoidal shape, a heat dissipation area of the pin 105 is increased, thereby achieving good heat dissipation effect.

In a possible implementation, the transverse section of the pin 105 is of a circular shape, and the longitudinal section is of a rectangular shape. When the transverse section is of the circular shape, a contact area between the pin 105 and the circuit board is increased, thereby increasing soldering strength between the magnetic device 100 and the circuit board, reducing heat generated from a contact point between the pin 105 and the circuit board, and increasing a through-current area of the pin 105. When the longitudinal section is of the rectangular shape, a heat dissipation area of the pin 105 is increased, thereby achieving good heat dissipation effect.

In a possible implementation, the transverse section of the pin 105 is of a circular shape, and the longitudinal section is of a T shape. When the transverse section is of the circular shape, a contact area between the pin 105 and the circuit board is increased, thereby increasing soldering strength between the magnetic device 100 and the circuit board, reducing heat generated from a contact point between the pin 105 and the circuit board, and increasing a through-current area of the pin 105. When the longitudinal section is of the T shape, a heat dissipation area of the pin 105 is increased, thereby achieving good heat dissipation effect.

In a possible implementation, the transverse section of the pin 105 is of a circular shape, and the longitudinal section is of a trapezoidal shape. When the transverse section is of the circular shape, a contact area between the pin 105 and the circuit board is increased, thereby increasing soldering strength between the magnetic device 100 and the circuit board, reducing heat generated from a contact point between the pin 105 and the circuit board, and increasing a through-current area of the pin 105. When the longitudinal section is of the trapezoidal shape, a heat dissipation area of the pin 105 is increased, thereby achieving good heat dissipation effect.

In a possible implementation, the transverse section of the pin 105 is of a rectangular shape, and the longitudinal section is of a rectangular shape. When the transverse section is of the rectangular shape, a contact area between the pin 105 and the circuit board is increased, thereby increasing soldering strength between the magnetic device 100 and the circuit board, reducing heat generated from a contact point between the pin 105 and the circuit board, and increasing a through-current area of the pin 105. When the longitudinal section is of the rectangular shape, a heat dissipation area of the pin 105 is increased, thereby achieving good heat dissipation effect.

In a possible implementation, the transverse section of the pin 105 is of a rectangular shape, and the longitudinal section is of a T shape. When the transverse section is of the rectangular shape, a contact area between the pin 105 and the circuit board is increased, thereby increasing soldering strength between the magnetic device 100 and the circuit board, reducing heat generated from a contact point between the pin 105 and the circuit board, and increasing a through-current area of the pin 105. When the longitudinal section is of the T shape, a heat dissipation area of the pin 105 is increased, thereby achieving good heat dissipation effect.

In a possible implementation, the transverse section of the pin 105 is of a rectangular shape, and the longitudinal section is of a trapezoidal shape. When the transverse section is of the rectangular shape, a contact area between the pin 105 and the circuit board is increased, thereby increasing soldering strength between the magnetic device 100 and the circuit board, reducing heat generated from a contact point between the pin 105 and the circuit board, and increasing a through-current area of the pin 105. When the longitudinal section is of the trapezoidal shape, a heat dissipation area of the pin 105 is increased, thereby achieving good heat dissipation effect.

An embodiment of this application provides a method for manufacturing the magnetic device 100. The magnetic device 100 includes a magnetic core 107, a winding, and a plurality of pins 105. Parts of two ends of the winding that pass through a base are the pins 105. A first metal layer 1051 and a second metal layer 1052 are sequentially stacked on a part or all of a side surface of a pin 105.

The manufacturing method includes: winding the winding on a winding framework of the magnetic device; soldering the first metal layer to a part or all of the side surface of the pin of the magnetic device; assembling the magnetic core and the base; and immersing the pin in tin, soldering the second metal layer to an outer side of the first metal layer, and removing a solder icicle.

For ease of understanding, the following describes in detail the method for manufacturing the magnetic device 100 in this embodiment of the present invention in a specific application scenario.

Step 1: Wire winding: An aluminum wire is wound on a winding framework of the magnetic device 100.

Step 2: Soldering: An insulation layer of the pin 105 is removed by using a chemical corrosion method or a laser method, and the first metal layer 1051 is soldered to the pin 105, where the soldering process includes cold pressure welding, resistance welding, and ultrasonic welding. In this case, the first metal layer 1051 is coated on a part or all of the side surface of the pin 105 of the magnetic device 100.

Step 3: Bottom plate assembling: The magnetic core 107 with the winding and the base 103 are assembled.

Step 4: Immersion in tin: The pin 105 is immersed in tin to coat the second metal layer 1052 on the outer side of the first metal layer 1051, and a solder icicle is removed.

An embodiment of this application provides an electronic device. The electronic device includes a circuit board and the magnetic device 100 as described above. The magnetic device 100 is mounted on the circuit board by using the pins 105. The magnetic device 100 includes a magnetic core 107, a winding, and a plurality of pins 105. Parts of two ends of the winding that pass through a base are the pins 105. A first metal layer 1051 and a second metal layer 1052 are sequentially stacked on a part or all of a side surface of a pin 105. The first metal layer 1051 is coated on a part or all of the side surface of the pin 105, and the first metal layer 1051 has low resistivity. The second metal layer 1052 is coated on an outer side of the first metal layer 1051, and the second metal layer 1052 has a low melting point and can be quickly solidified, which facilitates soldering.

It should be noted that a process of fixing the magnetic device 100 on the circuit board is not limited in this embodiment of this application. For example, the pin 105 of the magnetic device 100 may be fixed on the circuit board by using a process of wave soldering, laser welding, or reflow soldering.

The foregoing descriptions are merely specific implementations of the present invention, but are not intended to limit the protection scope of this application. The protection scope of this application is defined by the appended claims.

## Claims

1. A magnetic device (100), comprising a magnetic core (107), a base (103), a winding (101), and a plurality of pins (105), wherein the winding (101) is arranged inside the magnetic core (107) and parts of two ends of the winding (101) that pass through the base (103) are the pins (105), and a first metal layer (1051) and a second metal layer (1052) are sequentially stacked on a part or all of a side surface of each pin (105) of the plurality of pins (105);
the first metal layer (1051) is coated on a part or all of the side surface of each pin (105); and
the second metal layer (1052) is coated on an outer side of the first metal layer (1051), wherein the winding (101) comprises an aluminum wire, the first metal layer (1051) comprises a copper-aluminum composite foil, and the second metal layer (1052) comprises a tin layer or a tin alloy layer; and the copper-aluminum composite foil comprises two layers, a first layer of the copper-aluminum composite foil is an aluminum layer, a second layer of the copper-aluminum composite foil is a copper layer, the aluminum layer is in contact with the winding (101), and the copper layer is in contact with the second metal layer (1052).

2. The magnetic device (100) according to claim 1, wherein a transverse section of each pin (105) is of a U shape, a circular shape, or a rectangular shape.

3. The magnetic device (100) according to claim 1, wherein a longitudinal section of each pin (105) is of a rectangular shape, a T shape, or a trapezoidal shape.

4. A method for manufacturing a magnetic device (100), wherein the magnetic device (100) comprises a magnetic core (107), a base (103), a winding (101), and a plurality of pins (105), parts of two ends of the winding (101) that pass through the base (103) are the pins (105), and a first metal layer (1051) and a second metal layer (1052) are sequentially stacked on a part or all of a side surface of each pin (105) of the plurality of pins (105), wherein the winding (101) comprises an aluminum wire, the first metal layer (1051) comprises a copper-aluminum composite foil, and the second metal layer (1052) comprises a tin layer or a tin alloy layer; and the copper-aluminum composite foil comprises two layers, a first layer of the copper-aluminum composite foil is an aluminum layer, a second layer of the copper-aluminum composite foil is a copper layer, the aluminum layer is in contact with the winding (101), and the copper layer is in contact with the second metal layer (1052); and
the method comprises:
winding the winding (101) on a winding framework of the magnetic device (100);
soldering the first metal layer (1051) to a part or all of the side surface of each pin (105);
assembling the magnetic core (107) and the base (103); so that the winding (101) is arranged inside the magnetic core (107) and
immersing each pin (105) in tin, soldering the second metal layer (1052) to an outer side of the first metal layer (1051), and removing a solder icicle.

5. An electronic device, comprising a circuit board and the magnetic device (100) according to any one of claims 1 to 3, wherein
the magnetic device (100) is mounted on the circuit board by using the pins (105).

## Patentansprüche

1. Magnetische Vorrichtung (100), umfassend einen magnetischen Kern (107), eine Basis (103), eine Wicklung (101) und eine Vielzahl von Stiften (105), wobei die Wicklung (101) innerhalb des magnetischen Kerns (107) angeordnet ist und Teile von zwei Enden der Wicklung (101), die durch die Basis (103) verlaufen, die Stifte (105) sind und eine erste Metallschicht (1051) und eine zweite Metallschicht (1052) nacheinander auf einem Teil von oder einer ganzen Seitenoberfläche jedes Stifts (105) der Vielzahl von Stiften (105) gestapelt sind;
die erste Metallschicht (1051) auf einen Teil von oder die ganze Seitenoberfläche jedes Stifts (105) aufgetragen ist; und
die zweite Metallschicht (1052) auf eine Außenseite der ersten Metallschicht (1051) aufgetragen ist, wobei die Wicklung (101) einen Aluminiumdraht umfasst, die erste Metallschicht (1051) eine Kupfer-Aluminium-Verbundfolie umfasst und die zweite Metallschicht (1052) eine Zinnschicht oder eine Zinnlegierungsschicht umfasst; und die Kupfer-Aluminium-Verbundfolie zwei Schichten umfasst, eine erste Schicht der Kupfer-Aluminium-Verbundfolie eine Aluminiumschicht ist, eine zweite Schicht der Kupfer-Aluminium-Verbundfolie eine Kupferschicht ist, die Aluminiumschicht in Kontakt mit der Wicklung (101) steht und die Kupferschicht in Kontakt mit der zweiten Metallschicht (1052) steht.

2. Magnetische Vorrichtung (100) nach Anspruch 1, wobei ein Querschnitt jedes Stifts (105) eine U-Form, eine Kreisform oder eine rechteckige Form hat.

3. Magnetische Vorrichtung (100) nach Anspruch 1, wobei ein Längsschnitt jedes Stifts (105) eine rechteckige Form, eine T-Form oder eine Trapezform hat.

4. Verfahren zum Herstellen einer magnetischen Vorrichtung (100), wobei die magnetische Vorrichtung (100) einen magnetischen Kern (107), eine Basis (103), eine Wicklung (101) und eine Vielzahl von Stiften (105) umfasst, Teile von zwei Enden der Wicklung (101), die durch die Basis (103) verlaufen, die Stifte (105) sind und eine erste Metallschicht (1051) und eine zweite Metallschicht (1052) nacheinander auf einem Teil von oder einer ganzen Seitenoberfläche jedes Stifts (105) der Vielzahl von Stiften (105) gestapelt sind, wobei die Wicklung (101) einen Aluminiumdraht umfasst, die erste Metallschicht (1051) eine Kupfer-Aluminium-Verbundfolie umfasst und die zweite Metallschicht (1052) eine Zinnschicht oder eine Zinnlegierungsschicht umfasst; und die Kupfer-Aluminium-Verbundfolie zwei Schichten umfasst, eine erste Schicht der Kupfer-Aluminium-Verbundfolie eine Aluminiumschicht ist, eine zweite Schicht der Kupfer-Aluminium-Verbundfolie eine Kupferschicht ist, die Aluminiumschicht in Kontakt mit der Wicklung (101) steht und die Kupferschicht in Kontakt mit der zweiten Metallschicht (1052) steht; und
das Verfahren Folgendes umfasst:
Wickeln der Wicklung (101) auf einen Wickelrahmen der magnetischen Vorrichtung (100);
Löten der ersten Metallschicht (1051) an einen Teil von oder die gesamte Seitenoberfläche jedes Stifts (105);
Zusammensetzen des magnetischen Kerns (107) und der Basis (103); so dass die Wicklung (101) innerhalb des magnetischen Kerns (107) angeordnet ist, und
Eintauchen jedes Stifts (105) in Zinn, Löten der zweiten Metallschicht (1052) an eine Außenseite der ersten Metallschicht (1051) und Entfernen eines Lötzapfens.

5. Elektronische Vorrichtung, umfassend eine Leiterplatte und die magnetische Vorrichtung (100) nach einem der Ansprüche 1 bis 3, wobei
die magnetische Vorrichtung (100) unter Verwendung der Stifte (105) auf der Leiterplatte befestigt ist.

## Revendications

1. Dispositif magnétique (100), comprenant un noyau magnétique (107), une base (103), un enroulement (101), et une pluralité de broches (105), dans lequel l'enroulement (101) est disposé à l'intérieur du noyau magnétique (107) et des parties de deux extrémités de l'enroulement (101) qui traversent la base (103) sont les broches (105), et une première couche métallique (1051) et une seconde couche métallique (1052) sont empilées séquentiellement sur une partie ou la totalité d'une surface latérale de chaque broche (105) de la pluralité de broches (105) ;
la première couche métallique (1051) est revêtue sur une partie ou la totalité de la surface latérale de chaque broche (105) ; et
la seconde couche métallique (1052) est revêtue sur un côté extérieur de la première couche métallique (1051), dans lequel l'enroulement (101) comprend un fil d'aluminium, la première couche métallique (1051) comprend une feuille composite cuivre-aluminium, et la seconde couche métallique (1052) comprend une couche d'étain ou une couche d'alliage d'étain ; et la feuille composite cuivre-aluminium comprend deux couches, une première couche de la feuille composite cuivre-aluminium est une couche d'aluminium, une seconde couche de la feuille composite cuivre-aluminium est une couche de cuivre, la couche d'aluminium est en contact avec l'enroulement (101), et la couche de cuivre est en contact avec la seconde couche métallique (1052).

2. Dispositif magnétique (100) selon la revendication 1, dans lequel une section transversale de chaque broche (105) est en forme de U, de forme circulaire, ou de forme rectangulaire.

3. Dispositif magnétique (100) selon la revendication 1, dans lequel une section longitudinale de chaque broche (105) est de forme rectangulaire, en forme de T, ou de forme trapézoïdale.

4. Procédé de fabrication d'un dispositif magnétique (100), dans lequel le dispositif magnétique (100) comprend un noyau magnétique (107), une base (103), un enroulement (101), et une pluralité de broches (105), des parties des deux extrémités de l'enroulement (101) qui traversent la base (103) sont les broches (105), et une première couche métallique (1051) et une seconde couche métallique (1052) sont empilées séquentiellement sur une partie ou la totalité d'une surface latérale de chaque broche (105) de la pluralité de broches (105), dans lequel l'enroulement (101) comprend un fil d'aluminium, la première couche métallique (1051) comprend une feuille composite cuivre-aluminium, et la seconde couche métallique (1052) comprend une couche d'étain ou une couche d'alliage d'étain ; et la feuille composite cuivre-aluminium comprend deux couches, une première couche de la feuille composite cuivre-aluminium est une couche d'aluminium, une seconde couche de la feuille composite cuivre-aluminium est une couche de cuivre, la couche d'aluminium est en contact avec l'enroulement (101), et la couche de cuivre est en contact avec la seconde couche métallique (1052) ; et
le procédé comprend :
l'enroulement de l'enroulement (101) sur un cadre d'enroulement du dispositif magnétique (100) ;
la soudure de la première couche métallique (1051) sur une partie ou la totalité de la surface latérale de chaque broche (105) ;
l'assemblage du noyau magnétique (107) et de la base (103) ; de sorte que l'enroulement (101) est disposé à l'intérieur du noyau magnétique (107) et
l'immersion de chaque broche (105) dans de l'étain, la soudure de la seconde couche métallique (1052) sur un côté extérieur de la première couche métallique (1051), et le retrait d'un glaçon de soudure.

5. Dispositif électronique, comprenant une carte de circuit imprimé et le dispositif magnétique (100) selon l'une quelconque des revendications 1 à 3, dans lequel
le dispositif magnétique (100) est monté sur la carte de circuit imprimé à l'aide des broches (105).
